# EUROPÄISCHE PATENTSCHRIFT

(11) **EP 3 586 578 B1**
(45) Veröffentlichungstag und Bekanntmachung des Hinweises auf die Patenterteilung: **21.05.2025**
(21) Anmeldenummer: 18706259.1
(22) Anmeldetag: 20.02.2018
(51) Int. Cl.: H05K 9/00

(54) **SCHLAUCHKOMBINATION MIT ELEKTROMAGNETISCHER ABSCHIRMUNG, SCHLAUCH MIT ELEKTROMAGNETISCHER ABSCHIRMUNG UND VERWENDUNG EINER DERARTIGEN SCHLAUCHKOMBINATION BZW. EINES DERARTIGEN SCHLAUCHS**
HOSE COMBINATION WITH AN ELECTROMAGNETIC SHIELD, HOSE WITH AN ELECTROMAGNETIC SHIELD, AND USE OF SUCH A HOSE COMBINATION AND/OR OF SUCH A HOSE
COMBINAISON DE GAINES FLEXIBLES MUNIE D'UN BLINDAGE ÉLECTROMAGNÉTIQUE, GAINE FLEXIBLE MUNIE D'UN BLINDAGE ÉLECTROMAGNÉTIQUE ET UTILISATION DE LADITE COMBINAISON DE GAINES FLEXIBLES OU DE LADITE GAINE FLEXIBLE

(30) Priorität: 23.02.2017 DE 102017202944
(43) Veröffentlichungstag der Anmeldung: 01.01.2020
(73) Patentinhaber: Fränkische Industrial Pipes GmbH & Co. KG, 97486 Königsberg (DE)
(72) Erfinder: BIERMAIER, Peter, 9436 Balgach (CH); BLÜMMERT, Dominik, 97486 Königsberg (DE)
(74) Vertreter: Weickmann & Weickmann PartmbB
(86) Internationale Anmeldenummer: PCT/EP2018/054109
(87) Internationale Veröffentlichungsnummer: WO 2018/153841

(56) Entgegenhaltungen:
- WO-A1-2012/036320
- US-A1- 2015 237 770

## Beschreibung

Die Erfindung betrifft eine Schlauchkombination mit elektromagnetischer Abschirmung gemäß dem Oberbegriff des Anspruchs 1.

Derartige Schlauchkombinationen sind aus dem Stand der Technik an sich bekannt. Sie werden beispielsweise eingesetzt, um elektrische Leitungen vor dem Einfluss elektromagnetischer Störquellen zu schützen oder um stromdurchflossene Leiter zur Umgebung hin abzuschirmen. Häufig ist neben der elektromagnetischen Abschirmung auch noch wenigstens eine weitere Eigenschaften gewünscht, insbesondere die Bereitstellung eines Schutzes vor mechanischen Einflüssen, beispielsweise Abriebbeständigkeit und/oder Schlagfestigkeit, Hitzebeständigkeit und dergleichen mehr. Bei Verwendung einer Schlauchkombination kann der eine Schlauch im Hinblick auf die elektromagnetische Abschirmung ausgelegt werden, während der andere Schlauch im Hinblick auf die Erzielung der wenigstens einen weiteren Eigenschaft ausgelegt sein kann. Dies schließt jedoch nicht aus, dass beide Schläuche auch im Hinblick auf die jeweils andere Eigenschaft ausgebildet sein können.

Ein Anwendungsgebiet der bekannten Schlauchkombinationen ist beispielsweise die Kraftfahrzeugtechnik, insbesondere die Verkabelung von Kraftfahrzeugen und noch spezieller die Verkabelung im Motorraum von Kraftfahrzeugen. Insbesondere im letztgenannten Fall können die bekannten Schlauchkombinationen mit Vorteil eingesetzt werden, da hier der zur Verfügung stehende Bauraum bekanntermaßen sehr beengt ist, und somit elektromagnetische Störquellen die Umgebung stark beeinflussen können. Zudem werden in modernen Kraftfahrzeugen mit Elektro- bzw. Hybridantrieben immer häufiger sogenannte Hochvolt-Bordnetze verbaut, welche zur Umgebung hin abgeschirmt werden müssen.

An dieser Stelle sei darauf hingewiesen, dass die vorstehend erwähnten Eigenschaften der bekannten Schlauchkombinationen auch auf die erfindungsgemäßen Schlauchkombinationen zutreffen.

Aus dem Dokument US 2015/237770 A1 ist ein mehrschichtiges Kabel bekannt, welches eine innere, eine mittlere und eine äußere Schicht aufweist, wobei die innere und äußere Schicht aus einem Harz ausgebildet sind und die mittlere Schicht aus Metall ausgebildet ist. Ferner sei auf das Dokument WO 2012/036320 A1 hingewiesen.

Es ist Aufgabe der vorliegenden Erfindung, eine Schlauchkombination der eingangs genannten Art anzugeben, welche sich insbesondere zur Verlegung bei beengten räumlichen Verhältnissen, beispielsweise zur Verlegung im Motorraum von Kraftfahrzeugen, eignet.

Diese Aufgabe wird erfindungsgemäß durch eine Schlauchkombination gemäß Anspruch 1 gelöst.

Bei den bekannten Schlauchkombinationen stellte sich häufig das Problem, dass sich die Schlauchkombination aufgrund der Ineinanderanordnung von radial äußerem Schlauch und radial innerem Schlauch nur schwer verbiegen ließ, um ihr den für die Anordnung unter beengten räumlichen Verhältnissen erforderlichen Verlauf zu verleihen. Diesem Problem wird erfindungsgemäß dadurch begegnet, dass der radial innere Schlauch lose in dem radial äußeren Schlauch angeordnet ist, bzw. derart, dass er sich beim Verbiegen ohne weiteres von dem radial äußeren Schlauch löst. Der radial innere Schlauch und der radial äußeren Schlauch haben daher erfindungsgemäß überhaupt keine Verbindung zueinander oder haften allenfalls geringfügig aneinander an.

Um die elektromagnetische Abschirmungseigenschaft der Schlauchkombination sicherstellen zu können, wird in Weiterbildung der Erfindung vorgeschlagen, dass wenigstens der radial innere Schlauch die wenigstens eine elektrisch leitfähige Schicht aufweist. Auf diese Art und Weise ist der für die elektromagnetische Abschirmung verantwortliche, radial innere Schlauch allein durch die Anwesenheit des radial äußeren Schlauchs unabhängig von dessen genauer Ausbildung vor Beschädigungen durch äußere Einflüsse geschützt.

Zur Erzielung einer ausreichenden elektromagnetischen Abschirmung ist es vorteilhaft, wenn die elektrisch leitfähige Schicht aus einem Material gefertigt ist, dessen spezifische Leitfähigkeit bei einer Temperatur von etwa 25°C wenigstens 30 MS/m beträgt. Vorteilhafterweise kann die elektrisch leitfähige Schicht aus Kupfer und oder Gold und oder Silber gefertigt sein. Ferner ist es vorteilhaft, wenn die Dicke der elektrisch leitfähigen Schicht wenigstens 20 µm beträgt. Die elektrisch leitfähige Schicht kann also beispielsweise von einer Folie eines der genannten Metalle gebildet sein.

Da Metallfolien der genannten Dicke sehr beschädigungsanfällig sind, insbesondere für Reißen, ist es vorteilhaft, wenn die elektrisch leitfähige Schicht mit einer Stabilisierungsschicht verbunden ist. Neben der mechanischen Stabilisierung der elektrisch leitfähigen Schicht kann die Stabilisierungsschicht aber auch noch die Aufgabe übernehmen, die elektrisch leitfähige Schicht vor Korrosion zu schützen. Grundsätzlich ist es denkbar, die elektrisch leitfähige Schicht sandwich-artig zwischen zwei derartigen Stabilisierungsschichten einzubetten. In diesem Fall stellt sich jedoch das Problem der elektrischen Kontaktierung der elektrisch leitfähigen Schicht, beispielswiese um diese mit einem Stecker, insbesondere dem Gehäuse des Steckers, oder/und mit der Masse des Kraftfahrzeugs zu verbinden. Daher ist es alternativ auch denkbar, die elektrisch leitfähige Schicht auf der von der Stabilisierungsschicht abgewandten Seite mit einer weiteren Metallschicht zu versehen, welche sowohl die Korrosionsbeständigkeit als auch die elektrische Kontaktierbarkeit der elektrisch leitfähigen Schicht sicherstellt. So kann beispielsweise eine Kupferschicht verzinnt oder versilbert oder vergoldet werden, beispielsweise durch Bedampfen.

Die Stabilisierungsschicht und die elektrisch leitfähige Schicht können sowohl unter Verwendung eines Haftvermittlers oder Klebers als auch durch ein thermisches Verfahren miteinander verbunden sein. **In** Weiterbildung der Erfindung wird vorgeschlagen, dass die Stabilisierungsschicht auf die elektrisch leitfähige Schicht auflaminiert ist. Beispielsweise kann die Stabilisierungsschicht aus Kunststoff hergestellt sein, beispielsweise Polyester oder Polyethylenterephtalat. Ferner können die Stabilisierungsschicht oder/und der Haftvermittler bzw. Kleber eingefärbt sein, insbesondere in einer Signalfarbe, beispielsweise orange.

Alternativ ist es jedoch auch denkbar, dass die Stabilisierungsschicht als Trägerschicht ausgebildet ist, auf welche die elektrisch leitfähige Schicht beispielsweise aufgedampft wird. Beispielsweise kann die Trägerschicht von einem, vorzugsweise aus Polyesterfasern hergestellten, Vlies, insbesondere Spinnvlies, gebildet sein, dessen Flächengewicht vorzugsweise höchstens 100 g/m² beträgt. Auf dieses Vlies kann dann eines der vorstehend genannten Metalle aufgetragen werden, beispielsweise mittels eines Vakuumverfahrens, insbesondere mittels thermischem Verdampfen oder Sputtern. Dabei kann das Vlies einlagig oder auch mehrlagig ausgebildet sein.

Wenn die Stabilisierungsschicht radial außerhalb der elektrisch leitfähigen Schicht angeordnet ist, so kann die Stabilisierungsschicht die elektrisch leitfähige Schicht vor einer Beschädigung durch den radial äußeren Schlauch schützen, beispielsweise dann, wenn sich der radial innere Schlauch und der radial äußere Schlauch aufgrund ihrer losen Ineinanderanordnung bei der Verlegung der Schlauchkombination relativ zueinander bewegen.

**In** der Praxis hat es sich als vorteilhaft erwiesen, wenn das Verhältnis der radialen Dicke der elektrisch leitfähigen Schicht zur radialen Dicke der Stabilisierungsschicht zwischen etwa 0,75 und etwa 1,25 beträgt. Beispielsweise kann die radiale Dicke der Stabilisierungsschicht bzw. Trägerschicht etwa 23 µm betragen, was bei einer radialen Dicke der elektrisch leitfähigen Schicht von 20 µm zu einem Wert des Verhältnisses von etwa 0,87 führt.

Um eine gute Verformbarkeit des die elektrisch leitfähige Schicht aufweisenden Schlauchs gewährleisten zu können, wird ferner vorgeschlagen, dass die radiale Dicke des die elektrisch leitfähige Schicht aufweisenden Schlauchs höchstens 250 µm, vorzugsweise höchstens 100 µm, noch bevorzugter höchstens 50 µm, beträgt. Durch die Wahl einer radialen Dicke in dem vorstehend angegebenen Bereich trägt der die elektrisch leitfähige Schicht aufweisende Schlauch zudem nur geringfügig zum Gesamtgewicht der Schlauchkombination bei.

Um den die elektrisch leitfähige Schicht aufweisenden Schlauch in einfacher Weise herstellen zu können, wird gemäß der Erfindung vorgeschlagen, dass er aus einem flächigen Material durch Falten gebildet ist. Ein derartiges Herstellungsverfahren ist beispielsweise in der DE 10 2011 086 191 A1 der Anmelderin beschrieben, deren diesbezügliche Offenbarung hiermit durch Bezugnahme zum Teil der vorliegenden Offenbarung gemacht wird. Zur Erhöhung der mechanischen Stabilität der Verbindung der beiden seitlichen Randkanten des flächigen Materials ist es dabei vorgesehen, dass diese einander überlappend angeordnet sind. Dabei kann die Überlappung beispielsweise 10-15% der Umfangslänge des die elektrisch leitfähige Schicht aufweisenden Schlauchs betragen.

Generell, jedoch nicht erfindungsgemäß, ist es auch möglich, den Schlauch dadurch aus dem flächigen Material herzustellen, dass man das flächige Material schraubenwendelartig wickelt, beispielsweise schraubenwendelartig um das zu schützende Kabel legt. Dabei kann beim Wickeln der gleiche Schichtaufbau verwendet werden wie beim zuvor beschriebenen Falten. Um die Abschirmeigenschaften zu behalten, sollte sich das flächige Material um etwa ein Drittel seiner Breite überlappen. Um beim Wickeln die Abschirmeigenschaften zu verbessern, kann man eine Kontaktierung der leitfähigen Schichten beispielsweise dadurch sicherstellen, dass das flächige Material in Längsrichtung gefaltet wird, beispielsweise um seine Längsmittellinie. Um das flächige Material fixieren zu können, kann es ferner mit einem leitfähigen Kleber versehen sein.

Um die elektrisch leitfähigen Schichten der beiden seitlichen Randkanten elektrisch miteinander verbinden zu können, wird ferner vorgeschlagen, dass eine der seitlichen Randkanten des flächigen Materials zurückgefaltet ist, vorzugsweise einmal zurückgefaltet ist. Bildet die elektrisch leitfähige Schicht beispielsweise die radial innere Schicht, so wird sie durch dieses Zurückfalten, das heißt das Umschlagen des flächigen Materials auf sich selbst, radial außen angeordnet, sodass sie dann, wenn die radial innen angeordnete elektrische leitfähige Schicht der jeweils anderen seitlichen Randkanten mit der betrachteten Randkante zur Überlappung gebracht wird, mit dieser in Kontakt tritt und somit elektrisch verbunden wird.

Zur Verbindung der beiden seitlichen Randkanten kann beispielsweise ein Klebeband verwendet werden, beispielsweise ein Klebeband, das zwischen den beiden einander überlappenden seitlichen Randkanten des flächigen Materials angeordnet ist, oder ein Klebeband, welches die frei zugängliche seitliche Randkante überdeckt. Wird der elektrische Kontakt zwischen den seitlichen Randkanten des flächigen Materials durch Zurückfalten einer der seitlichen Randkanten ermöglicht, so ist es vorteilhaft, wenn das Klebeband wenigstens ein elektrisch leitfähiges Material umfasst.

Alternativ oder zusätzlich zur Verwendung eines derartigen Klebebands können die beiden seitlichen Randkanten aber auch miteinander verlötet oder verschweißt, insbesondere unter Einsatz des Laserschweiß-Verfahrens, sein. In diesem Fall könnte auch auf die Überlappung verzichtet werden, wodurch man einen homogeneren Aufbau des die elektrisch leitfähige Schicht aufweisenden Schlauchs erzielen könnte.

Alternativ oder zusätzlich kann die Verbindung der beiden einander überlappenden seitlichen Randkanten des flächigen Materials durch Prägen verstärkt werden. Werden die Stabilisierungs- bzw. Trägerschicht und die elektrisch leitfähige Schicht im Zuge des Prägens zumindest punktuell durchstoßen, so kann hierdurch auch die elektrische Verbindung der beiden seitlichen Randkanten hergestellt werden.

Um eine Variation des Durchmessers des die elektrisch leitfähige Schicht aufweisenden Schlauchs ermöglichen zu können, ist gemäß der Erfindung vorgesehen, dass ein vorbestimmter Umfangsabschnitt des Schlauchs auf den restlichen Umfangsabschnitt umgefaltet bzw. in diesen eingefaltet ist. Der Vorteil dieser Faltung liegt in der Aufweitbarkeit des Schlauchdurchmessers im Bedarfsfall. Ein Bedarf kann beispielsweise dadurch entstehen, dass der Schlauch an einem seiner Enden über einen Anschlussstecker gezogen werden muss.

Wird der die elektrisch leitfähige Schicht aufweisende Schlauch wie vorstehend beschrieben im Durchmesser aufgeweitet, so kann sie beispielsweise allein durch Verwendung eines Schrumpfschlauches oder Schrumpfgewebes als radial äußerer Schlauch, z.B. am Stecker, fixiert werden. Wurde der Schlauch auf seiner gesamten Länge aufgeweitet, kann so der Schlauchdurchmesser auf der restlichen Länge wieder verringert werden. Insbesondere für den Einsatz in Motorräumen von Kraftfahrzeugen kann so für eine saubere Verlegung gesorgt werden.

Im Kraftfahrzeugbau (z.B. im Motorraum, Karosserie) werden immer häufiger sogenannte Rund-Oval-Wellrohre verwendet, d.h. Wellrohre, deren Querschnittsfläche abschnittsweise rund oder oval ausgebildet ist. Hierbei wird die Querschnittsform, nicht aber die Querschnittsfläche der äußeren Hülle geändert, um die Kabel auch bei beengten räumlichen Verhältnissen verlegen zu können. Aufgrund der dünnen Wandstärke ist die erfindungsgemäße Schlauchkombination sehr gut für solche Anwendungen geeignet.

Die in Kraftfahrzeugen zu verlegenden Kabelbäume weisen nicht selten eine Länge von mehr als 5 m auf und erstrecken sich durch verschiedene Abschnitte des Kraftfahrzeugs, beispielsweise den Motorraum, den Fahrgastraum, den Kofferraum und dergleichen mehr. In diesen verschiedenen Abschnitten können unterschiedliche Anforderungen an den Schutz der Leitungen des Kabelbaums bestehen. Beispielsweise benötigt man im Motorraum Hitzeschutz, während im Fahrgastraum erhöhte Brandanforderungen bestehen könnten. Teilweise sind im Fahrgastraum auch vorbereitet Kanäle für den Kabelbaum vorhanden sein, so dass hier eventuell auch kein zusätzlicher Schutz erforderlich ist. Daher ist es vorteilhaft, wenn die Eigenschaften der Schläuche der Schlauchkombination abschnittsweise unterschiedlich sind.

In Weiterbildung der Erfindung kann ferner vorgesehen sein, dass zwischen dem radial inneren Schlauch und dem radial äußeren Schlauch eine aus einem Geräusche dämpfenden Material gefertigte Schicht angeordnet ist. Das Geräusche dämpfende Material kann dabei nur im Hinblick auf die Vermeidung der Entstehung von Geräuschen oder/und im Hinblick auf die Vermeidung der Weiterleitung von bereits entstandenen Geräuschen ausgewählt werden. Beispielsweise kann das Geräusche dämpfende Material ein, vorzugsweise aus Polyesterfasern hergestelltes, Vlies, insbesondere Spinnvlies, sein.

Der radial äußere Schlauch ist von einem, vorzugsweise aus Kunststofffasern gebildeten, Geflecht, Gestrick, Gewebe oder Gewirke gebildet. Alternativ umfasst der radial äußere Schlauch ein extrudiertes Kunststoffwellrohr. Ferner kann der radial äußere Schlauch mehrlagig ausgebildet sein. Wie bereits erwähnt kann der radial äußere Schlauch Schlagschutzeigenschaften aufweisen und hierzu beispielsweise aus Aramid gefertigt sein. Er kann jedoch auch dem Abriebschutz oder UV-Schutz dienen und hierzu beispielsweise aus Polyurethan gefertigt sein. Als weitere gegebenenfalls wünschenswerte Schutzeigenschaften seien hier noch Brandschutz, Hitzeschutz, Vibrationsschutz und Bissschutz, z.B. gegen Marderbiss, erwähnt.

In Weiterbildung der Erfindung können die Schlauchkombination und insbesondere der radial innere Schlauch der Schlauchkombination derart bemessen sein, dass die Schlauchkombination als so genannter "Summenschirm" eingesetzt werden kann. Bei einem solchen Summenschirm werden üblicherweise mehrere stromdurchflossene Leitungen durch eine gemeinsame EMV-Abschirmung (EMV - elektromagnetische Verträglichkeit) geschützt.

Die Erfindung betrifft nach einem weiteren Aspekt die Verwendung einer erfindungsgemäßen Schlauchkombination zum Schutz elektrischer Leitungen vor dem Einfluss elektromagnetischer Störquellen oder/und zum Abschirmen von stromdurchflossenen Leitern, insbesondere in Motorräumen von Kraftfahrzeugen. Bezüglich der mit diesen weiteren Aspekten erzielbaren Vorteile sei auf die vorstehende Diskussion der erfindungsgemäßen Schlauchkombination verwiesen.

Die Erfindung wird im Folgenden an einem Ausführungsbeispiel an Hand der beigefügten Zeichnung näher erläutert werden. Es stellt dar.
- Figur 1: eine Querschnittsdarstellung einer ersten Ausführungsform einer erfindungsgemäßen Schlauchkombination;
- Figuren 2a und 2b: schematische Darstellungen zur Erläuterung der Durchmesserveränderbarkeit durch Um- bzw. Einfalten eines Schlauchs;
- Figur 3: eine schematische Darstellung zur Erläuterung der Herstellung des radial inneren Schlauchs der erfindungsgemäßen Schlauchkombination aus einem länglichen Bandmaterial durch Zusammenlegen um seine Längsachse;
- Figur 4: eine Querschnittsdarstellung ähnlich Figur 1 einer zweiten Ausführungsform einer erfindungsgemäßen Schlauchkombination;
- Figur 5: eine schematische Darstellung eines Messaufbaus zur Bestimmung der Schirmdämpfung des radial inneren Schlauchs der in den Figuren 1 und 4 dargestellten Schlauchkombinationen;
- Figuren 6 und 7: die Messergebnisse der Schirmdämpfungsmessung an dem radial inneren Schlauch der in Figur 1 dargestellten Schlauchkombination unter Verwendung des in Figur 5 dargestellten Messaufbaus.

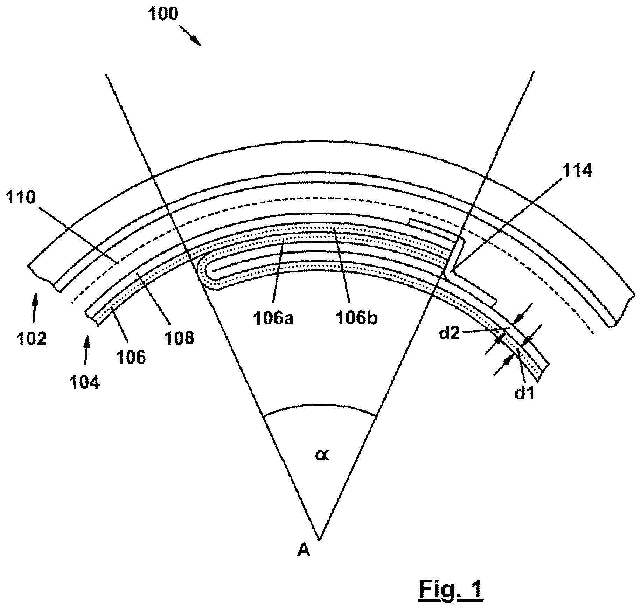

In Figur 1 ist eine erste Ausführungsform einer erfindungsgemäßen Schlauchkombination ganz allgemein mit 100 bezeichnet. Die Schlauchkombination 100 umfasst einen radial äußeren Schlauch 102 und einen radial inneren Schlauch 104.

In dem dargestellten Ausführungsbeispiel ist der radial äußere Schlauch 102 als Wellrohr ausgebildet. Beispielsweise kann das Wellrohr aus Polyurethan gefertigt sein, um einen Abriebschutz für den radial inneren Schlauch 104 bereitzustellen.

Der radial innere Schlauch 104 ist in dem dargestellten Ausführungsbeispiel als mehrlagige Folie ausgebildet, die eine innere Schicht 106 und eine äußere Schicht 108 umfasst. Die innere Schicht 106 ist dabei von einer Kupferfolie gebildet, während die äußere Schicht 108 von einer Kunststofffolie, beispielsweise einer Polyesterfolie, gebildet ist, welche auf die Kupferfolie auflaminiert ist. Die Dicke d1 der Kupferfolie kann beispielsweise 20 µm betragen, während die Dicke d2 der Kunststofffolie etwa 23 µm betragen kann. Die Kunststofffolie 108 schützt die Kupferfolie 106 nicht nur vor Reißen, sondern auch vor Beschädigung durch einen Kontakt mit dem radial äußeren Schlauch 102. Als weitere Schutzmaßnahme kann zwischen dem radial äußeren Schlauch 102 und dem radial inneren Schlauch 104 gewünschtenfalls auch noch eine weitere Schutzschicht 110 vorgesehen sein, die in dem dargestellten Ausführungsbeispiel lediglich grob schematisch gestrichelt dargestellt ist und beispielsweise von einem Vlies, insbesondere einem Vlies der eingangs erläuterten Eigenschaften, gebildet sein kann.

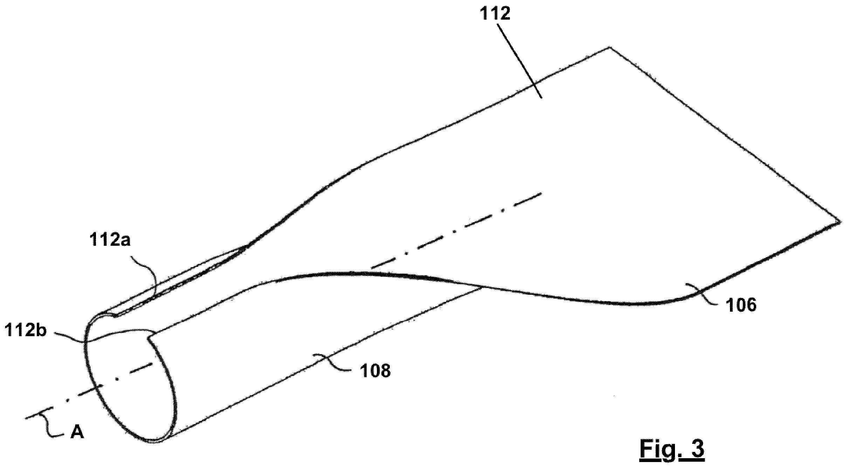

Wie in Figur 1 dargestellt ist, ist der radial innere Schlauch 104 nicht mit einer durchgehend geschlossenen Oberfläche ausgebildet. Vielmehr wird er aus einem flächigen Bandmaterial 112 durch Zusammenlegen um seine Längsachse A hergestellt, wie dies schematisch in Figur 3 dargestellt ist. Dabei überlappen sich die beiden seitlichen Randbereiche 112a und 112b um einen Umfangswinkel α (siehe Figur 1), dessen Wert bis zu 50° oder mehr betragen kann. Diese Überlappung hat den Vorteil der Verbesserung der elektromagnetischen Abschirmungseigenschaften der Kupferfolie 106.

Um die elektromagnetischen Abschirmungseigenschaften der Kupferfolie 106 noch weiter verbessern zu können, ist es vorteilhaft, wenn die beiden seitlichen Randbereiche 106a und 106b der Kupferfolie 106 derart aneinander anliegen, dass sie in elektrisch leitendem Kontakt miteinander stehen. Hierzu kann einer der beiden Randbereiche, im dargestellten Ausführungsbeispiel der Randbereich 106a, umgeschlagen werden, d.h. auf sich selbst zurückgefaltet werden, wodurch die Kupferfolie 106 im Bereich der Zurückfaltung von radial innen nach radial außen gebracht wird. Sie steht somit im Überlappungsbereich α in elektrisch leitendem Kontakt mit der unmittelbar auf ihr aufliegenden Kupferfolie des Randbereichs 106b.

Um die beiden Randbereiche 112a und 112b des Bandmaterials 112, aus dem der radial innere Schlauch 104 gebildet ist, mechanisch miteinander verbinden zu können, ist ferner ein Klebeband 114 vorgesehen. Zusätzlich oder alternativ ist es jedoch auch denkbar, die beiden Randbereiche 112a und 112b miteinander durch Löten oder Schweißen zu verbinden. Ferner ist es denkbar, zwischen den Randbereichen 106a und 106b der Kupferfolie 106 ein elektrisch leitfähiges, doppelseitiges Klebeband anzuordnen.

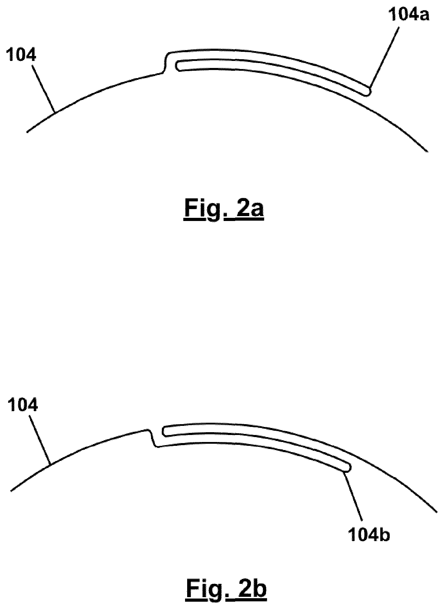

Um den Durchmesser des radial inneren Schlauchs 104 im Bedarfsfall verändern zu können, kann, wie in Figur 2a dargestellt, ein vorbestimmter Umfangsabschnitt 104a des Schlauchs 104 auf den restlichen Umfangsabschnitt umgefaltet werden. Alternativ ist es jedoch auch denkbar, den vorbestimmten Umfangsabschnitt 104b in den restlichen Schlauch 104 einzufalten (siehe Figur 2b).

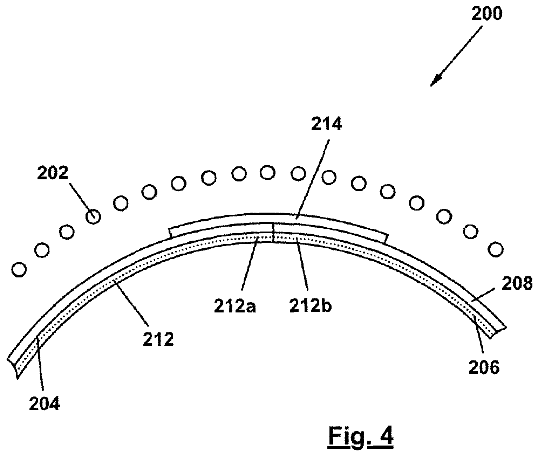

**In** Figur 4 ist eine vereinfachte zweite Ausführungsform einer erfindungsgemäßen Schlauchkombination dargestellt, die im Wesentlichen der ersten Ausführungsform gemäß Figur 1 spricht. Daher sind in Figur 4 analoge Teile mit den gleichen Bezugszeichen versehen wie in Figur 1, jedoch vermehrt um die Zahl 100. Darüber hinaus wird die Schlauchkombination 200 der Figur 4 im Folgenden nur insoweit beschrieben werden, als sie sich von der Schlauchkombination 100 gemäß Figur 1 unterscheidet, auf deren Beschreibung hiermit ansonsten ausdrücklich verwiesen sei.

Bei der Schlauchkombination 200 gemäß Figur 4 ist der radial äußere Schlauch 202 von einem Gestrick gebildet, welches beispielsweise aus Aramidfasern hergestellt sein kann, um einen Schlagschutz für den radial inneren Schlauch 204 bereitzustellen. Darüber hinaus umfasst der radial innere Schlauch 204 ein Vlies 208, welches mit einer Kupferschicht 206 bedampft ist. Auch der radial innere Schlauch 204 der Ausführungsform gemäß Figur 4 kann unter Einsatz des in Figur 3 dargestellten Verfahrens aus einem Bandmaterial 212 hergestellt sein. Dabei stoßen jedoch die Randbereiche 212a und 212b des Bandmaterials 212 ohne Überlappung aneinander an und sind mittels eines Klebebands 214 mechanisch miteinander verbunden.

Das Abschirmungsvermögen des radial inneren Schlauchs 104 bzw. 204 kann durch das Maß der so genannten Schirmdämpfung beschrieben werden. Diese Schirmdämpfung ist das Verhältnis einer Störleistung im Raum zur maximal hervorgerufenen Leistung innerhalb der/des vom Schlauch umgebenen Leitung/Kabels. Genauer gesagt ist die Schirmdämpfung das Verhältnis des Werts der elektrischen Feldstärke außerhalb des Schlauchs zum Wert der elektrischen Feldstärke innerhalb des Schlauchs. Sie wird in der Einheit "dB" angegeben.

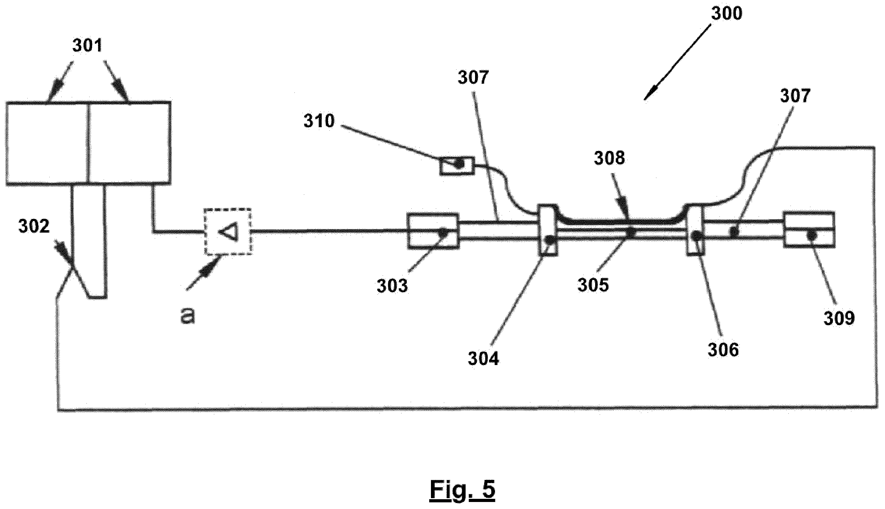

Die Schirmdämpfung kann nach dem so genannten Paralleldraht-Verfahren nach der VG 95214-6 mit dem in Figur 5 dargestellten Aufbau 300 bestimmt werden. Als Prüfling 305 wurde im vorliegenden Fall der Innenleiter eines Koaxialkabels verwendet, dessen Abschirmung zuvor entfernt und durch den erfindungsgemäßen radial inneren Schlauch 104 bzw. 204 ersetzt worden war. Der Prüfling 305 wurde an zwei Messaufnahmen 304 und 306 angeschlossen, die im konkreten Versuchsaufbau von zwei Messingplatten mit aufgelöteten N-Buchsen gebildet waren. Der Innenleiter des Koaxialkabels verlief durch die N-Buchsen hindurch, während der Schlauch mittels Schraubschellen mit den N-Buchsen elektrisch leitend verbunden wurde. Zwischen den Messaufnahmen 304 und 306 verlief ferner ein als Störquelle dienender Paralleldraht 308. Die Störleistung wurde dem Paralleldraht 308 von einem Netzwerkanalysator 301 (HF-Generator der Fa. Rohde & Schwarz, Typ SMA100C, Kenn-Nr. 2.81.01, kalibriert 06/2012; und Messempfänger der Fa. Rohde & Schwarz, Typ ESU8, Kenn-Nr. 2.70.05, kalibriert 09/2011) über einen Leistungsteiler 302 und die Messaufnahme 306 zugeführt. Zudem war der Paralleldraht 308 an der Messaufnahme 304 mit einer Abschlussimpedanz 310 (Fa. Spinner, Typ 50Ω/25W, Kenn-Nr. 5.10.01, kalibriert 10/2012) verbunden. Der Prüfling 305 war an der Messaufnahme 306 über ein Schirmrohr 307 mit einem schirmenden Gehäuse 309 verbunden, das mit einer Abschlussimpedanz (Fa. Rosenberger, Typ 50Ω/0,25W, Kenn-Nr. 5.10.16, kalibriert 10/2012) versehen war, und an der Messaufnahme 304 über ein weiteres Schirmrohr 307 mit einem schirmenden Gehäuse 303, über das das im Prüfling 305 induzierte Signal dem Netzwerkanalysator 301 zugeführt wurde. Zwischen dem schirmenden Gehäuse 303 und dem Netzwerkanalysator kann erforderlichenfalls ferner ein Leistungsverstärker a vorgesehen werden. Die Messungen erfolgten auf einem Holztisch in einer geschirmten Messkabine. Die Schirmdämpfung wurde im Frequenzbereich von 10 kHz bis 300 MHz durchgeführt. Die Messung wurde in einem Zustand des erfindungsgemäßen radial inneren Schlauchs 104 bzw. 204 durchgeführt, in dem er einen Durchmesser von 20 mm aufwies.

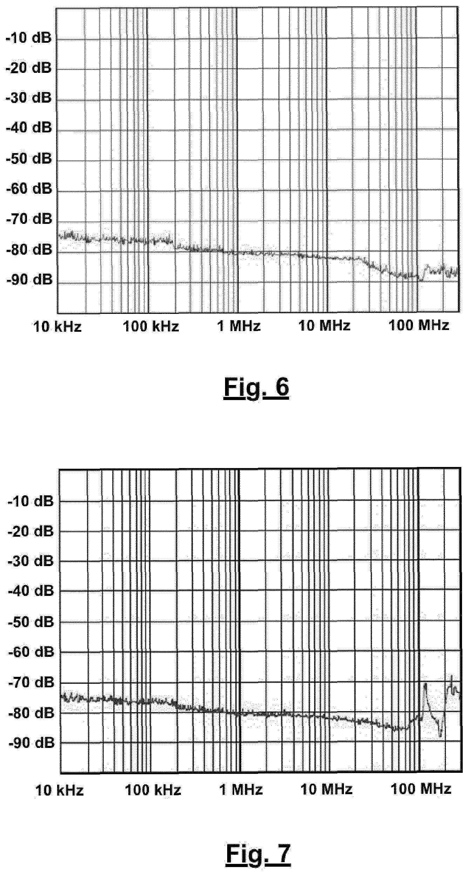

Das Messergebnis für den radial inneren Schlauch 104 gemäß Figur 1 ist in Figur 6 dargestellt, während das Messergebnis für den radial inneren Schlauch 204 gemäß Figur 4 in Figur 7 dargestellt ist. Obgleich beide Schläuche 104 und 204 im gesamten Frequenzbereich von 10 kHz bis 300 MHz eine hervorragende Dämpfung von besser als -70 dB aufweisen, erkennt man, dass der Schlauch 104 gemäß Figur 1 aufgrund der Überlappung und der elektrischen Kontaktierung der beiden Randbereiche 106a und 106b der Kupferfolie 106 im Bereich hoher Frequenzen bessere Abschirmungseigenschaften aufweist als der Schlauch 204 gemäß Figur 4.

## Patentansprüche

1. Schlauchkombination (100) mit elektromagnetischer Abschirmung, umfassend:
einen radial inneren Schlauch (104) und
einen radial äußeren Schlauch (102),
wobei der radial innere Schlauch (104) wenigstens eine elektrisch leitfähige Schicht (106) aufweist,
wobei der radial innere Schlauch (104) in dem radial äußeren Schlauch (102) lose oder von diesem derart lösbar aufgenommen ist, dass er sich beim Verbiegen ohne weiteres von dem radial äußeren Schlauch löst, und
wobei der radial äußere Schlauch (102) von einem, vorzugsweise aus Kunststofffasern gebildeten, Geflecht, Gestrick, Gewebe oder Gewirke gebildet ist oder wobei der radial äußere Schlauch (102) ein extrudiertes Kunststoffwellrohr umfasst,
wobei der die wenigstens eine elektrisch leitfähige Schicht (106) aufweisende radial innere Schlauch (104) aus einem flächigen Material (112) durch Falten gebildet ist, und
wobei die beiden seitlichen Randkanten (112a, 112b) des flächigen Materials (112) einander überlappend angeordnet sind,
**dadurch gekennzeichnet, dass** ein vorbestimmter Umfangsabschnitt (104a, 104b) des radial inneren Schlauchs (104) auf den restlichen Umfangsabschnitt umgefaltet bzw. in diesen eingefaltet ist.

2. Schlauchkombination nach Anspruch 1,
**dadurch gekennzeichnet, dass** wenigstens der radial innere Schlauch (104) die wenigstens eine elektrisch leitfähige Schicht (106) aufweist.

3. Schlauchkombination nach Anspruch 1 oder 2,
**dadurch gekennzeichnet, dass** die elektrisch leitfähige Schicht (106) aus einem Material gefertigt ist, dessen spezifische Leitfähigkeit bei einer Temperatur von etwa 25°C wenigstens 30 MS/m beträgt.

4. Schlauchkombination nach einem der Ansprüche 1 bis 3,
**dadurch gekennzeichnet, dass** die Dicke (d1) der elektrisch leitfähigen Schicht (106) wenigstens 20 µm beträgt.

5. Schlauchkombination nach einem der Ansprüche 1 bis 4,
**dadurch gekennzeichnet, dass** die elektrisch leitfähige Schicht (106) mit einer Stabilisierungsschicht (108) verbunden ist,
wobei die Stabilisierungsschicht (108) beispielsweise auf die elektrisch leitfähige Schicht (106) auflaminiert oder als Trägerschicht ausgebildet ist.

6. Schlauchkombination nach Anspruch 5,
**dadurch gekennzeichnet, dass** die Stabilisierungsschicht (108) radial außerhalb der elektrisch leitfähigen Schicht (106) angeordnet ist.

7. Schlauchkombination nach Anspruch 5 oder 6,
**dadurch gekennzeichnet, dass** das Verhältnis (d1/d2) der radialen Dicke (d1) der elektrisch leitfähigen Schicht (106) zur radialen Dicke (d2) der Stabilisierungsschicht (108) zwischen etwa 0,75 und etwa 1,25 beträgt.

8. Schlauchkombination nach einem der Ansprüche 1 bis 7,
**dadurch gekennzeichnet, dass** eine der seitlichen Randkanten (112a, 112b) des flächigen Materials (112) zurückgefaltet ist.

9. Schlauchkombination nach einem der Ansprüche 1 bis 8,
**dadurch gekennzeichnet, dass** der radial äußere Schlauch (102) mehrlagig ausgebildet ist.

10. Verwendung einer Schlauchkombination (100) nach einem der Ansprüche 1 bis 9 zum Schutz elektrischer Leitungen vor dem Einfluss elektromagnetischer Störquellen oder/und zum Abschirmen von stromdurchflossenen Leitern, insbesondere in Motorräumen von Kraftfahrzeugen.

## Claims

1. Hose combination (100) with electromagnetic shielding, comprising:
a radially inner hose (104) and
a radially outer hose (102),
wherein the radially inner hose (104) has at least one electrically conductive layer (106),
wherein the radially inner hose (104) is loosely or detachably received in the radially outer hose (102) in such a way that it readily detaches from the radially outer hose when bent, and
wherein the radially outer hose (102) is formed by a braided, knitted, woven or warp-knitted fabric, preferably formed from plastic fibers, or wherein the radially outer hose (102) comprises an extruded corrugated plastic tube,
wherein the radially inner hose (104) comprising the at least one electrically conductive layer (106) is formed from a flat material (112) by folding, and
wherein the two lateral edges (112a, 112b) of the flat material (112) are arranged to overlap one another,
**characterised in that** a predetermined circumferential section (104a, 104b) of the radially inner hose (104) is folded over onto or folded into the remaining circumferential section.

2. Hose combination according to claim 1,
**characterised in that** at least the radially inner hose (104) has the at least one electrically conductive layer (106).

3. Hose combination according to claim 1 or 2,
**characterised in that** the electrically conductive layer (106) is made of a material whose specific conductivity at a temperature of about 25°C is at least 30 MS/m.

4. Hose combination according to any one of claims 1 to 3,
**characterised in that** the thickness (d1) of the electrically conductive layer (106) is at least 20 µm.

5. Hose combination according to any one of claims 1 to 4,
**characterised in that** the electrically conductive layer (106) is connected to a stabilising layer (108),
wherein the stabilising layer (108) is, for example, laminated onto the electrically conductive layer (106) or formed as a carrier layer.

6. Hose combination according to claim 5,
**characterised in that** the stabilising layer (108) is arranged radially outside the electrically conductive layer (106).

7. Hose combination according to claim 5 or 6,
**characterised in that** the ratio (d1/d2) of the radial thickness (d1) of the electrically conductive layer (106) to the radial thickness (d2) of the stabilising layer (108) is between about 0.75 and about 1.25.

8. Hose combination according to any one of claims 1 to 7,
**characterised in that** one of the lateral edges (112a, 112b) of the flat material (112) is folded back.

9. Hose combination according to any one of claims 1 to 8,
**characterised in that** the radially outer hose (102) is formed in several layers.

10. Use of a hose combination (100) according to any one of claims 1 to 9 for protecting electrical lines from the influence of electromagnetic interference sources and/or for shielding current-carrying conductors, in particular in engine compartments of motor vehicles.

## Revendications

1. Une combinaison de tuyaux (100) avec blindage électromagnétique, comprenant :
un tuyau radialement intérieur (104) et
un tuyau radialement extérieur (102),
dans lequel le tuyau radialement intérieur (104) présente au moins une couche électriquement conductrice (106),
dans lequel le tuyau radialement intérieur (104) est logé de manière détachée dans le tuyau radialement extérieur (102) ou pouvant en être détaché de telle sorte qu'il se détache facilement du tuyau radialement extérieur lorsqu'il est plié, et
dans lequel le tuyau radialement extérieur (102) est formé d'un tressage, d'un tricot, d'un tissu ou d'un tissu à mailles formés de préférence en fibres plastiques, ou dans lequel le tuyau radialement extérieur (102) comprend un tube ondulé en plastique extrudé,
dans lequel le tuyau radialement intérieur (104) présentant au moins une couche électriquement conductrice (106) est formé à partir d'un matériau plat (112) par pliage, et
dans lequel les deux bords latéraux (112a, 112b) du matériau plat (112) sont disposées de manière à se chevaucher,
**caractérisée en ce qu'**une section périphérique prédéterminée (104a, 104b) du tuyau radialement intérieur (104) est repliée sur la section périphérique restante ou est insérée dans celle-ci.

2. La combinaison de tuyaux selon la revendication 1,
**caractérisée en ce qu'**au moins le tuyau radialement intérieur (104) présente ladite au moins une couche électroconductrice (106).

3. La combinaison de tuyaux selon la revendication 1 ou 2,
**caractérisée en ce que** la couche électroconductrice (106) est fabriquée d'un matériau dont la conductivité spécifique est d'au moins 30 MS/m à une température d'environ 25 °C.

4. La combinaison de tuyaux selon l'une des revendications 1 à 3,
**caractérisée en ce que** l'épaisseur (d1) de la couche électriquement conductrice (106) est d'au moins 20 µm.

5. La combinaison de tuyaux selon l'une des revendications 1 à 4,
**caractérisée en ce que** la couche électroconductrice (106) est reliée à une couche de stabilisation (108),
dans lequel la couche de stabilisation (108) est par exemple laminée sur la couche électroconductrice (106) ou formée en tant que couche de support.

6. La combinaison de tuyaux selon la revendication 5,
**caractérisée en ce que** la couche de stabilisation (108) est disposée radialement à l'extérieur de la couche électroconductrice (106).

7. La combinaison de tuyaux selon la revendication 5 ou 6,
**caractérisée en ce que** le rapport (d1/d2) entre l'épaisseur radiale (d1) de la couche électriquement conductrice (106) et l'épaisseur radiale (d2) de la couche de stabilisation (108) est compris entre environ 0,75 et environ 1,25.

8. La combinaison de tuyaux selon l'une des revendications 1 à 7,
**caractérisée en ce que** l'un des bords latéraux (112a, 112b) du matériau plat (112) est replié.

9. La combinaison de tuyaux selon l'une des revendications 1 à 8,
**caractérisée en ce que** le tuyau radialement extérieur (102) est formé de plusieurs couches.

10. Une utilisation d'une combinaison de tuyaux (100) selon l'une des revendications 1 à 9 pour protéger des lignes électriques de l'influence de sources d'interférences électromagnétiques et/ou pour protéger les conducteurs parcourus par un courant, en particulier dans des compartiments moteur de véhicules automobiles.
